# EUROPEAN PATENT APPLICATION

(11) **EP 2 555 244 A1**
(43) Date of publication of application: **06.02.2013**
(21) Application number: 11176476.7
(22) Date of filing: 03.08.2011
(51) Int. Cl.: H01L 27/146

(54) **A method of producing a photodiode device and a photodiode device comprising an etch stop layer**

(71) Applicant: austriamicrosystems AG, 8141 Unterpremstätten (AT)
(72) Inventor: Teva, Jordi, 8020 Graz (AT); Eilmsteiner, Gerhard, 8700 Leoben (AT); Jonak-Auer, Ingrid, 8043 Graz (AT); Kraft, Jochen, 8600 Oberaich (AT)
(74) Representative: Epping - Hermann - Fischer

(57) **Abstract**

The method is used to produce a photodiode device comprising a semiconductor base layer (1), which is intrinsically conductive or provided with a doping for low conductivity, a first contact region (2) and a second contact region (3) at the front surface of the base layer, and a terminal layer (4) located at the rear surface of the base layer. The method comprises the steps of providing a handling wafer (19), and arranging the terminal layer and the base layer above the handling wafer in such a manner that the terminal layer is located between the base layer and the handling wafer, and an etch stop layer (5) is formed between the base layer and the handling wafer. Then the first contact region and the second contact region are produced, and the handling wafer is removed at least up to the etch stop layer in such a manner that the terminal layer is maintained.

## Description

The invention relates to a method of producing a photodiode device for backside illumination, comprising a terminal layer at the rear surface, and a photodiode device comprising an etch stop layer.

In general, backside illuminated photodiodes combined with 3D integration techniques offer the possibility to lower the assembly cost compared to traditional hybrid designs, where the photodiodes and the circuitry are wire bonded. The costs of production methods using SOI bonding are high, so that there is a demand for less expensive production methods.

US 2006/0157811 describes a photodiode device having an optically transparent conductive electrode layer, which serves as optical window, and an ohmic backside contact surface.

US 2010/0193893 describes a 3D integration of float zone integrated photodiodes by means of SOI bonding formation.

US 2010/0213565 describes a photodiode array made of frontside and backside electrical contacts for improved response.

A method which uses a pn junction to generate an etch stop is described in R. L. Gealer, R. H. Hammerle, H. Karsten, H. S. Wroblowa, "Electrochemical etch-stop control for silicon containing electronic components", J. Appl. Electrochemistry 18, 463 - 468 (1988).

It is an object of this invention to provide a new production method for photodiode devices intended for backside illumination, and to provide a new structure of photodiode devices, particularly a new structure which is improved with respect to the production process.

This object is achieved with the method of producing a photodiode device according to claim 1 and with the photodiode device according to claim 8, respectively. Embodiments and alterations derive from the dependent claims.

The method is used to produce a photodiode device comprising a semiconductor base layer of a first type of conductivity, which is intrinsically conductive or provided with a doping for low conductivity, a first contact region of the first type of conductivity and a second contact region of an opposite second type of conductivity located at the front surface of the base layer, and a terminal layer of the first type of conductivity or the second type of conductivity located at the rear surface of the base layer.

The method comprises the steps of providing a handling wafer, and arranging the terminal layer and the base layer above the handling wafer in such a manner that the terminal layer is located between the base layer and the handling wafer, and an etch stop layer is formed between the base layer and the handling wafer. Then the first contact region and the second contact region are produced, and the handling wafer is removed at least up to the etch stop layer in such a manner that the terminal layer is maintained.

In a variant of the method, the etch stop layer is arranged between the handling wafer and the terminal layer, and the etch stop layer is a semiconductor material of a type of conductivity that is opposite to the type of conductivity of the terminal layer.

In a further variant of the method, the etch stop layer is arranged between the handling wafer and the terminal layer, and the etch stop layer is SiGeC.

In a further variant of the method, the terminal layer is provided with a conductivity that is higher than the conductivity of the base layer, and the etch stop layer is formed by the terminal layer.

In a further variant of the method, the handling wafer is a semiconductor material provided with the second type of conductivity.

In a further variant of the method, a junction of opposite types of conductivity of the base layer and the handling wafer generates a depletion region, which is used as the etch stop layer.

In a further variant of the method, the handling wafer is provided with a conductivity that is higher than the conductivity of the base layer, and the handling wafer is removed up to the depletion region in such a manner that a residual layer portion of the handling wafer forms the terminal layer.

Embodiments of the photodiode device comprise a semiconductor base layer having a front surface and an opposite rear surface and being intrinsically conductive or provided with a low doping for high resistivity of a first type of conductivity, a first contact region of the first type of conductivity and a second contact region of an opposite second type of conductivity located at the front surface, and a terminal layer of the first type of conductivity or the second type of conductivity located at the rear surface of the base layer. An etch stop layer is located at a rear surface of the terminal layer opposite to the base layer.

In further embodiments of the photodiode device the etch stop layer is a semiconductor material and has the type of conductivity that is opposite to the type of conductivity of the terminal layer.

In further embodiments of the photodiode device the etch stop layer is SiGeC.

For a more complete understanding of the present invention, and the advantages thereof, reference is now made to the following descriptions taken in conjunction with the accompanying drawings, in which:
Figure 1 shows a cross-section of an intermediate product of an embodiment of the photodiode device.
Figure 2 shows a cross-section of an embodiment obtained from the intermediate product according to Figure 1.
Figure 3 shows a cross-section of an intermediate product of a further embodiment of the photodiode device.
Figure 4 shows a cross-section of an embodiment obtained from the intermediate product according to Figure 3.
Figure 5 shows a cross-section of an intermediate product of a further embodiment of the photodiode device.
Figure 6 shows a cross-section of an embodiment obtained from the intermediate product according to Figure 5.

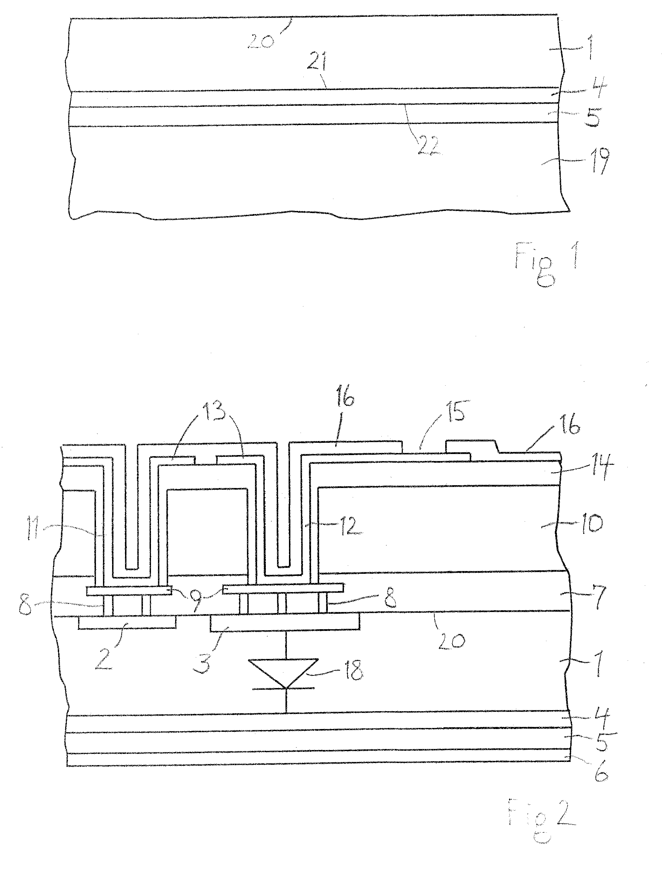

Figure 1 shows a cross-section of a handling wafer 19 carrying an etch stop layer 5, a terminal layer 4 and a base layer 1, which has a front surface 20 and a rear surface 21 forming the boundary face to the terminal layer 4. The rear surface 22 of the terminal layer 4 is the boundary face to the etch stop layer 5. The front surface 20 is provided for the electric terminals and the wiring of the photodiode device. The handling wafer 19 may be silicon, for instance. The etch stop layer 5 may be produced by an epitaxial growth on the surface of the handling wafer 19. The terminal layer 4 is provided with high doping concentration as an anode or cathode layer of the photodiode. The base layer 1 may be intrinsically conducting semiconductor material, especially silicon, of either type of conductivity, rendering the structure of a PIN photodiode, or it may comprise a low doping for a high resistivity. The base layer 1 may be grown by epitaxy on the terminal layer 4.

Figure 2 shows a cross-section according to Figure 1 after a further processing of the device. At the front surface 20 of the base layer 1, a first contact region 2 and a second contact region 3 are formed as doped regions of opposite types of conductivity and provided as terminals of the photodiode, which is schematically represented by the circuit symbol 18. On the side opposite to the handling wafer 19, a substrate 10, which may be a semiconductor material, is connected to the base layer 1 by an intermediate layer 7, which may be an oxide of the semiconductor material. Contact plugs 8 connected to portions of a structured contact layer 9, which may be a metal, are arranged in the intermediate layer 7 on the first and second contact regions 2, 3, respectively.

The first contact region 2 is provided with a first substrate via 11, and the second contact region 3 is provided with a second substrate via 12. The vias 11, 12 can be formed by a metalization 13, which may be separated from the substrate 10 by a dielectric layer 14. The contact plugs 8 and the vias 11, 12 are provided as electric terminal connections of the photodiode and are only an example, which may be substituted with electric connections or wirings of the photodiode that differ from the device structure shown in Figure 2. The metalization 13 can be covered with a passivation layer 16, which may comprise contact windows 15 for an external electric contact.

When the structure of the photodiode device is complete, the handling wafer 19 is removed up to the etch stop layer 5. If the handling wafer is a semiconductor material like silicon, it can be removed by grinding and a posterior wet etching that stops on the etch stop layer 5. The grinding process produces a rough surface, which is smoothed by the wet etching step. Using the dedicated etch stop layer 5, a high selectivity of the wet etching process is achieved with respect to the semiconductor material of the handling wafer 19.

The etch stop layer may be a doped silicon layer, which has a sufficiently good etch selectivity versus intrinsically conducting silicon in alkaline solutions. Potassium hydroxide (KOH) or tetramethylammonium hydroxide (TMAH) can be used as the etching agent.

The etch stop layer 5 may as well be SiGeC, which has a good selectivity versus silicon in wet etching processes. The selectivity depends on the C and Ge composition of the layer. Further to the mentioned alkaline solutions, HNA, which is a common isotropic etchant for silicon, can be used as the etching agent. Other possibilities of etch stop layers are an electrochemical etch stop and an etch stop that is effected at the transition from high to low doping concentrations in silicon.

After the removal of the handling wafer 19, the rear side of the device, which is intended for light incidence, may be coated, particularly with a passivation layer 6. Its main purpose is a protection of the photodiode against an external attack of chemicals or adverse environmental conditions. The passivation layer 6 can also function as an antireflective coating. The passivation layer 6 may be a single layer or a layer sequence and may comprise, for instance, silicon oxide, silicon nitride, silicon oxidnitride or a combination of any of these, which can be deposited by a PECVD technique (plasma-enhanced chemical vapor deposition). A dedicated antireflective coating may also be applied, in order to maximize the quantum efficiency for a given wavelength or a range of wavelengths, depending on the application.

Embodiments according to Figures 1 and 2 may particularly comprise, apart from an intrisically conductive base layer 1 (p- or n- conductivity), the following combinations:

| etch stop layer 5 | terminal layer 4 |
|---|---|
| p+ | n+ (cathode) |
| n+ | p+ (anode) |
| SiGeC | n+ (cathode) |
| SiGeC | p+ (anode) |

The doped layers can be produced with different dopants, like As for n-type and In or B for p-type conductivity, for instance.

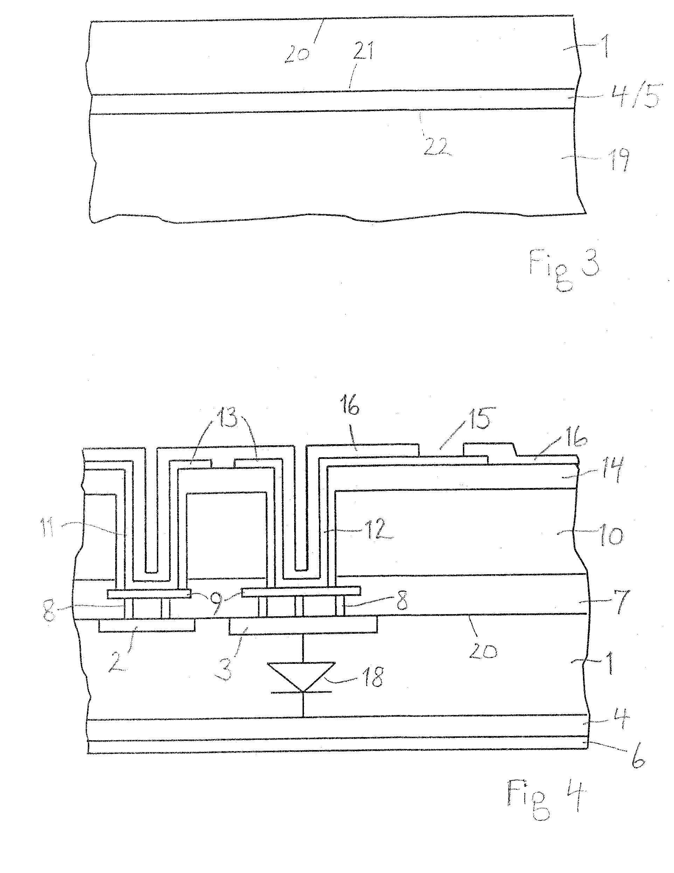

Figure 3 shows a cross-section according to Figure 1 for a further embodiment, in which the terminal layer 4 is used as the etch stop layer 5. For this purpose the terminal layer 4 is highly doped for either conductivity type (p+ or n+ conductivity). The rear surface 22 of the terminal layer 4 is the boundary to the handling wafer 19.

Figure 4 shows a cross-section according to Figure 2 for the embodiment according to Figure 3. The dedicated etch stop layer 5 is substituted with the terminal layer 4, and a passivation layer 6 and/or an antireflective coating may be applied to the rear side, which is intended for light incidence. The other elements of this embodiment may be similar to the corresponding elements of the embodiment according to Figure 2 and are designated with the same reference numerals. Depending on its conductivity, the terminal layer 4 functions as anode (p+ conductivity) or cathode (n+ conductivity).

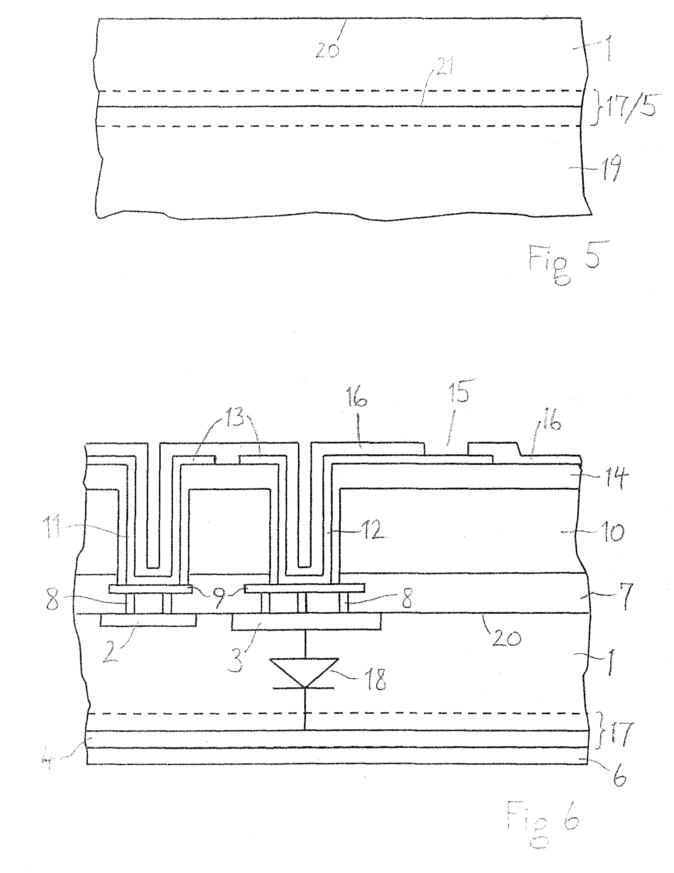

Figure 5 shows a cross-section according to Figure 1 for a further embodiment, in which a pn junction is formed between the handling wafer 19 and the base layer 1. By an application of a bias voltage to the pn junction, a depletion region 17 can be generated and used as the etch stop layer 5. For this purpose the handling wafer 19 and the base layer 1 are provided with opposite types of conductivity. For example, the handling wafer 19 may have p+ or p- conductivity if the base layer 1 has n- conductivity. The rear surface 21 of the base layer 1 is the boundary to the handling wafer 19; there the pn junction is located and the depletion region 17 is generated.

Figure 6 shows a cross-section according to Figure 2 for the embodiment according to Figure 5. The terminal layer 4 is formed by a residual layer portion of the handling wafer 19. The other elements of this embodiment may be similar to the corresponding elements of the embodiment according to Figure 2 and are designated with the same reference numerals.

In the embodiment of Figures 5 and 6, the handling wafer 19 is preferably highly doped, and the base layer 1 may be grown epitaxially as an intrinsically conductive silicon layer. After the integration of the photodiode the handling wafer 19 can be removed by using an electrochemical etch stop, which stops in the depletion region 17 of the pn junction when a bias is applied. This method is described in detail in the publication of R. L. Gealer et al. mentioned in the introduction.

The described method of producing a photodiode device and the photodiode device comprising an etch stop layer offer new possibilities for fabricating three-dimensional integrated and backside illuminated photodiodes based on epitaxial processes, thereby substantially reducing the production costs, particularly when compared to conventional approaches using SOI materials.

### List of reference numerals

- 1: base layer
- 2: first contact region
- 3: second contact region
- 4: terminal layer
- 5: etch stop layer
- 6: passivation layer
- 7: intermediate layer
- 8: contact plug
- 9: contact layer
- 10: substrate
- 11: first substrate via
- 12: second substrate via
- 13: metalization
- 14: dielectric layer
- 15: contact window
- 16: passivation layer
- 17: depletion region
- 18: circuit symbol of photodiode
- 19: handling wafer
- 20: front surface of the base layer
- 21: rear surface of the base layer
- 22: rear surface of the terminal layer

## Claims

1. A method of producing a photodiode device, comprising:
- a semiconductor base layer (1) of a first type of conductivity, being intrinsically conductive or provided with a doping for low conductivity, and having a front surface (20) and an opposite rear surface (21),
- a first contact region (2) of the first type of conductivity and a second contact region (3) of an opposite second type of conductivity located at the front surface (20), and
- a terminal layer (4) of the first type of conductivity or the second type of conductivity located at the rear surface (21) of the base layer (1),
**characterized in that**
- a handling wafer (19) is provided,
- the terminal layer (4) and the base layer (1) are arranged above the handling wafer (19) in such a manner that the terminal layer (4) is located between the base layer (1) and the handling wafer (19), and an etch stop layer (5) is formed between the base layer (1) and the handling wafer (19),
- the first contact region (2) and the second contact region (3) are produced, and
- the handling wafer (19) is removed at least up to the etch stop layer (5) in such a manner that the terminal layer (4) is maintained.

2. The method of claim 1, further comprising:
the etch stop layer (5) being arranged between the handling wafer (19) and the terminal layer (4),
the etch stop layer (5) being a semiconductor material of a type of conductivity that is opposite to the type of conductivity of the terminal layer (4).

3. The method of claim 1, further comprising:
the etch stop layer (5) being arranged between the handling wafer (19) and the terminal layer (4),
the etch stop layer (5) being SiGeC.

4. The method of claim 1, wherein
the terminal layer (4) is provided with a conductivity that is higher than the conductivity of the base layer (1), and the etch stop layer (5) is formed by the terminal layer (4).

5. The method of claim 1, wherein
the handling wafer (19) is a semiconductor material provided with the second type of conductivity.

6. The method of claim 1, wherein
the handling wafer (19) is a semiconductor material provided with the second type of conductivity, a junction of the opposite types of conductivity of the base layer (1) and the handling wafer (19) generating a depletion region (17), and the depletion region (17) is used as the etch stop layer (5).

7. The method of claim 6, wherein
the handling wafer (19) is provided with a conductivity that is higher than the conductivity of the base layer (1), and the handling wafer (19) is removed up to the depletion region (17) in such a manner that a residual layer portion of the handling wafer (19) forms the terminal layer (4).

8. A photodiode device comprising
- a semiconductor base layer (1) having a front surface (20) and an opposite rear surface (21), and being intrinsically conductive or provided with a low doping for high resistivity of a first type of conductivity,
- a first contact region (2) of the first type of conductivity and a second contact region (3) of an opposite second type of conductivity located at the front surface (20), and
- a terminal layer (4) of the first type of conductivity or the second type of conductivity located at the rear surface (21) of the base layer (1),
**characterized in that**
- an etch stop layer (5) is located at a rear surface (22) of the terminal layer (4) opposite to the base layer (1).

9. The photodiode device of claim 1, wherein
the etch stop layer (5) is a semiconductor material and has the type of conductivity that is opposite to the type of conductivity of the terminal layer (4).

10. The photodiode device of claim 1, wherein
the etch stop layer (5) is SiGeC.
